# EUROPEAN PATENT APPLICATION

(11) **EP 4 806 641 A1**
(43) Date of publication of application: **16.09.2026**
(21) Application number: 26163905.8
(22) Date of filing: 11.03.2026
(51) Int. Cl.: B41F 15/08, B41F 15/36, H05K 3/12, B41N 1/24, B22F 12/30, B29C 64/245

(54) **SCREEN PRINTING PLATE AND EDGE PRINTING SYSTEM FOR THREE-DIMENSIONAL OBJECTS**

(30) Priority: 13.03.2025 TW 114109391
(71) Applicant: Prologium Technology Co., Ltd., Taoyuan City 320023 (TW)
(72) Inventor: LIN, Ji Jhong, 320023 Taoyuan City (TW); LIN, Chia Ming, 320023 Taoyuan City (TW); YANG, Szu-Nan, 320023 Taoyuan City (TW)
(74) Representative: Wang, Bo

(57) **Abstract**

A screen printing plate (1) is used for forming a printed object (92) onto a three-dimensional object (801), wherein the printed object (92) covers a top surface (801b) of the three-dimensional object (801) and a side surface (801a) adjacent to the top surface (801b). The screen printing plate (1) comprises a frame, a mesh component and a patterned blocking layer (40). The mesh component is disposed on the frame, whereby the mesh component has a squeegee contact surface and a substrate contact surface opposed to the squeegee contact surface. The patterned blocking layer (40) is disposed on the substrate contact surface of the mesh component to divide the mesh component into a printing material non-discharge area and a printing material discharge area. The printing material discharge area corresponds to the three-dimensional object (801) and is divided into a three-dimensional object stacking area and a non-three-dimensional object stacking area, wherein the patterned blocking layer forms a first limiting wall in the non-three-dimensional object stacking area as well as a second limiting wall in the three-dimensional object stacking area. The thickness of the first limiting wall is larger than the thickness of the second limiting wall.

## Description

### BACKGROUND OF THE INVENTION

### 1. Field of the invention

The present invention relates to a screen printing plate and an edge printing system, and more particularly, to a screen printing plate and an edge printing system for three-dimensional objects applied to a substrate having three-dimensional objects.

### 2. Description of the prior art

Screen printing technology is an important printing method that can print patterns onto substrates according to users' requirements. Screen printing technology has several advantages, including its suitability for large-scale production and the ability to produce stable and consistent prints. Therefore, screen printing plates can be applied in various industries. In recent years, technological developments have driven electronic products toward more compact, lightweight, and highly precise designs. As a result, screen printing technology has gradually been applied to the printing of high-precision electronic components, such as PCB substrates and other related components.

Currently, screen printing technology in the prior art is typically applied to substrates with flat surfaces. However, as user and market demands become increasingly diverse, substrate structures have becomes more complex. For example, the surface of a substrate may include three-dimensional objects of varying heights. In such cases, the resulting print patterns often fail to achieve the desired quality when using the screen printing technology in the prior art. In detail, the surface of the substrate is no longer uniform in height when the surface of the substrate comprises three-dimensional objects, causing the printing material and other substances intended to be transferred onto the surface of the substrate to be stretched or distorted during the printing process. As a result, the resulting print patterns may exhibit distortion, inaccurate pattern shapes, incorrect dimensions, and other defects, thereby failing to meet customer requirements.

Moreover, in the process of printing the substrate having the three-dimensional object using screen printing technology in the prior art, the distance between the screen printing plate and the substrate is excessively large and no supporting structure is disposed therebetween. Therefore, when the user pushes the printing material toward the printing openings with a squeegee, the screen printing plate is subjected to pressure, causing the mesh at the printing openings to deform downward during the printing process. The distribution of the printing material becomes uneven and may even overflow beyond the intended printing area, causing the printed pattern to exceed its boundaries or become blurred, thereby further reducing the printing yield. In addition, the excessive deformation of the screen printing plate results in damage and increases manufacturing costs.

Therefore, it is necessary to provide a screen printing plate that can be applied to the substrate having three-dimensional objects, so as to improve printing accuracy and yield to satisfy customer and market demands.

### SUMMARY OF THE INVENTION

In view of the foregoing, the present invention provides a screen printing plate used for forming a printed object onto a three-dimensional object. The printed object covers a top surface of the three-dimensional object and a side surface adjacent to the top surface. The screen printing plate comprises a frame, a mesh component, and a patterned blocking layer. The mesh component is disposed on the frame, and the mesh component has a squeegee contact surface and a substrate contact surface opposed to the squeegee contact surface. The patterned blocking layer is disposed on the substrate contact surface of the mesh component to divide the mesh component into a printing material non-discharge area and a printing material discharge area. The printing material discharge area corresponds to the three-dimensional object and is divided into a three-dimensional object stacking area and a non-three-dimensional object stacking area. Wherein, the patterned blocking layer forms a first limiting wall in the non-three-dimensional object stacking area, and the patterned blocking layer forms a second limiting wall in the three-dimensional object stacking area, the thickness of the first limiting wall is larger than the thickness of the second limiting wall.

Wherein, the patterned blocking layer of the first limiting wall is formed by stacking a first emulsion layer in a cured state and a second emulsion layer in a cured state, and the patterned blocking layer of the second limiting wall is formed by the first emulsion layer in a cured state.

Wherein, the thickness of the second emulsion layer is substantially the same as the height of the three-dimensional object.

Wherein, a material of the second emulsion layer is the same as that of the first emulsion layer.

Wherein, the first limiting wall surrounds the second limiting wall.

The present invention further provides an edge printing system for three-dimensional objects comprising a substrate, a screen printing plate, and a squeegee. The substrate has a three-dimensional object disposed on a surface thereof. The screen printing plate is disposed on the surface of the substrate, and the screen printing plate comprises a frame, a mesh component, and a patterned blocking layer. The mesh component is disposed on the frame, and the mesh component has a squeegee contact surface and a substrate contact surface opposed to the squeegee contact surface. The patterned blocking layer is disposed on the substrate contact surface of the mesh component to divide the mesh component into a printing material non-discharge area and a printing material discharge area. The printing material discharge area corresponds to the three-dimensional object and is divided into a three-dimensional object stacking area and a non-three-dimensional object stacking area. Wherein, the patterned blocking layer forms a first limiting wall in the non-three-dimensional object stacking area, and the patterned blocking layer forms a second limiting wall in the three-dimensional object stacking area. The thickness of the first limiting wall is larger than the thickness of the second limiting wall. The squeegee is configured to apply pressure on a printing material applied on the squeegee contact surface to allow the printing material to be discharged from the printing material discharge area and to form a coverage layer covering a portion of a top surface of the three-dimensional object and a side surface adjacent to the top surface.

Wherein, the patterned blocking layer of the first limiting wall is formed by stacking a first emulsion layer in a cured state and a second emulsion layer in a cured state, and the patterned blocking layer of the second limiting wall is formed by the first emulsion layer in a cured state.

Wherein, the thickness of the second emulsion layer is substantially the same as the height of the three-dimensional object.

Wherein, a material of the second emulsion layer is the same as that of the first emulsion layer.

Wherein, the first limiting wall surrounds the second limiting wall.

To summarize, the invention provides the screen printing plate and the edge printing system for three-dimensional objects. Wherein, the screen printing plate of the present invention comprises the first emulsion layer and the second emulsion layer. The screen printing plate of the present invention can efficiently control the flow direction of the printing material when printing by controlling the applied region and height of two emulsion layers. Additionally, the squeegee is configured to apply downward pressure to the screen printing plate of the present invention when printing the substrate having the three-dimensional object. The second emulsion layer can be configured to support the mesh component to avoid excessive deformation caused by downward pressure from the squeegee, thereby effectively preventing issues such as uneven printing material height or pattern distortion after printing. Furthermore, the present invention can ensure that the printing material forms a printing layer with a flat top surface, and further forms a complete pattern under the pressure of the squeegee. In summary, compared to the prior art, the present invention provides the screen printing plate and the edge printing system for three-dimensional objects that can be effectively applied to the substrates having the three-dimensional object, while also enabling the printing of stable and complete patterns to meet customer and market demands.

### BRIEF DESCRIPTION OF THE APPENDED DRAWINGS

FIG. 1 is a top view illustrating the screen printing plate according to one embodiment of the present invention.
FIG. 2A is a sectional diagram illustrating the section A-A of the screen printing plate of FIG. 1.
FIG. 2B is a sectional diagram illustrating the section B-B of the screen printing plate of FIG. 1.
FIG. 2C is a sectional diagram illustrating the section C-C of the screen printing plate of FIG. 1
FIG. 3A is a schematic diagram illustrating a usage scenario of the screen printing plate according to FIG. 1.
FIG. 3B is a schematic diagram illustrating a usage scenario of the screen printing plate according to FIG. 1.
FIG. 3C is a schematic diagram illustrating a usage scenario of the screen printing plate according to FIG. 1.
FIG. 3D is a schematic diagram illustrating a usage scenario of the screen printing plate according to FIG. 1.
FIG. 4A is a front view illustrating the substrate after printing.
FIG. 4B is a top view illustrating the substrate after printing.
FIG. 5 is a top view illustrating the screen printing plate according to one embodiment of the present invention.
FIG. 6A is a sectional diagram illustrating the section D-D of the screen printing plate of FIG. 5.
FIG. 6B is a sectional diagram illustrating the section E-E of the screen printing plate of FIG. 5.
FIG. 6C is a sectional diagram illustrating the section F-F of the screen printing plate of FIG. 5.
FIG. 7A is a front view illustrating the substrate after printing.
FIG. 7B is a top view illustrating the substrate after printing.

### DETAILED DESCRIPTION OF THE INVENTION

For the sake of the advantages, spirits and features of the present invention can be understood more easily and clearly, the detailed descriptions and discussions will be made later by way of the embodiments and with reference of the diagrams. It is worth noting that these embodiments are merely representative embodiments of the present invention, wherein the specific methods, devices, conditions, materials and the like are not limited to the embodiments of the present invention or corresponding embodiments. Moreover, the devices in the figures are only used to express their corresponding positions and are not drawing according to their actual proportion.

In the description of this specification, the description with reference to the terms "a specific embodiment", "another specific embodiment" or "parts of specific embodiments" etc. means that the specific feature, structure, material or feature described in conjunction with the embodiment include in at least one embodiment of the present invention. In this specification, the schematic representations of the above-mentioned terms do not necessarily refer to the same embodiment. Moreover, the described specific features, structures, materials or characteristics can be combined in any one or more embodiments in a suitable manner.

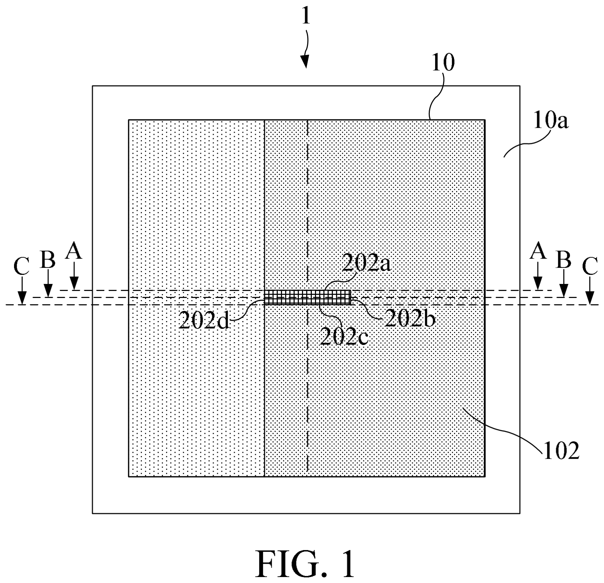

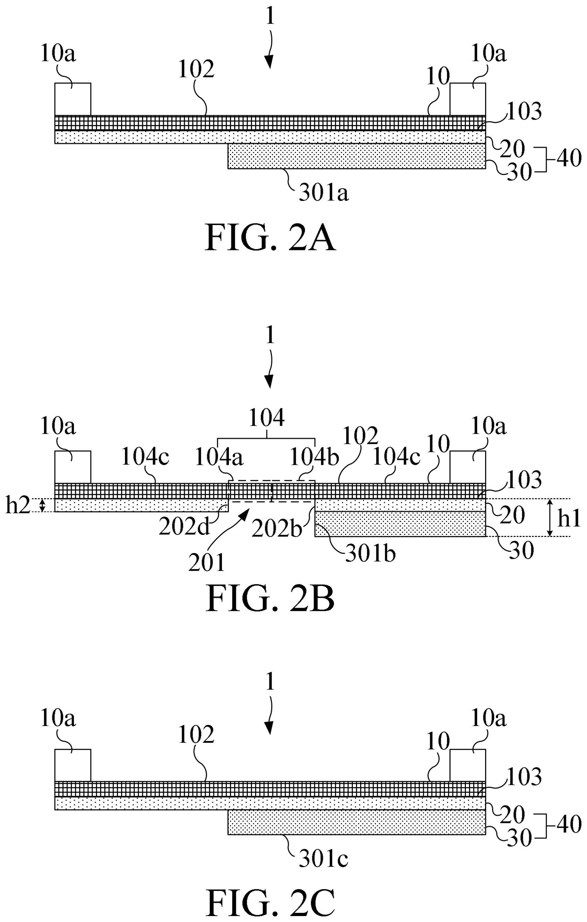

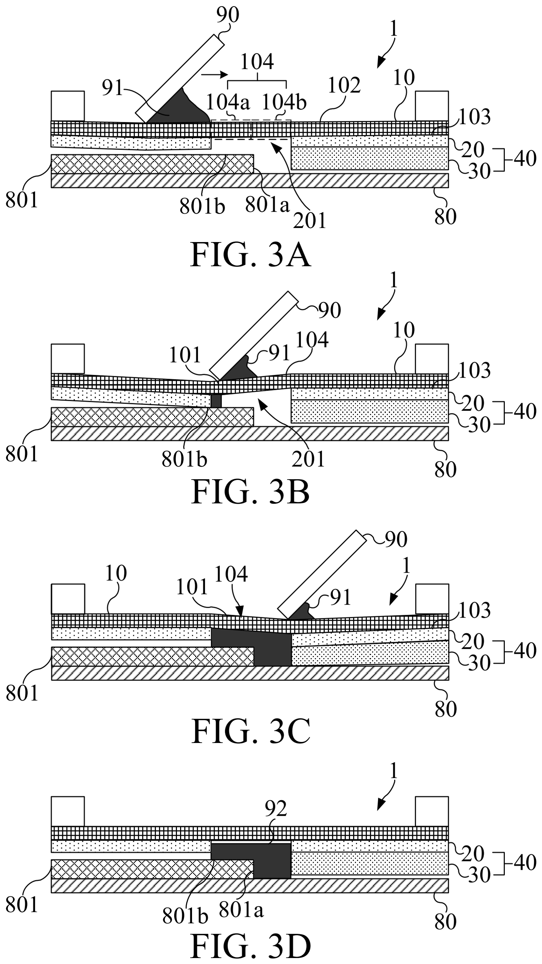

Please refer to FIG. 1, FIG. 2A, FIG. 2B, FIG. 2C, FIG. 3A, FIG. 3B, FIG. 3C, and FIG. 3D. FIG. 1 is a top view illustrating the screen printing plate 1 according to one embodiment of the present invention. FIG. 2A is a sectional diagram illustrating the section A-A of the screen printing plate of FIG. 1. FIG. 2B is a sectional diagram illustrating the section B-B of the screen printing plate of FIG. 1. FIG. 2C is a sectional diagram illustrating the section C-C of the screen printing plate of FIG. 1 FIG. 3A is a schematic diagram illustrating a usage scenario of the screen printing plate according to FIG. 1. FIG. 3B is a schematic diagram illustrating a usage scenario of the screen printing plate according to FIG. 1. FIG. 3C is a schematic diagram illustrating a usage scenario of the screen printing plate according to FIG. 1. FIG. 3D is a schematic diagram illustrating a usage scenario of the screen printing plate according to FIG. 1. The screen printing plate 1 of the present invention is used for forming a printed object onto a three-dimensional object 801. Wherein, the printed object covers a top surface of the three-dimensional object 801 and a side surface adjacent to the top surface. As shown in FIG. 1, FIG. 2A, FIG. 2B, FIG. 2C, FIG. 3A, FIG. 3B, FIG. 3C, and FIG. 3D, a screen printing plate 1 comprises a frame 10a, a mesh component 10 and a patterned blocking layer 40. The mesh component 10 is disposed on the frame 10a. The mesh component 10 has a squeegee contact surface 102 and a substrate contact surface 103 opposed to the squeegee contact surface 102. The patterned blocking layer 40 is disposed on the substrate contact surface 103 of the mesh component 10 to divide the mesh component 10 into a printing material non-discharge area 104c and a printing material discharge area 104. The printing material discharge area 104 corresponds to the three-dimensional object 801 and is divided into a three-dimensional object stacking area 104a and a non-three-dimensional object stacking area 104b. Wherein, the patterned blocking layer 40 forms a first limiting wall in the non-three-dimensional object stacking area 104b, and the patterned blocking layer 40 forms a second limiting wall in the three-dimensional object stacking area 104a. The thickness of the first limiting wall h1 is larger than the thickness of the second limiting wall h2.

Please refer to FIG. 2A, FIG. 2B, and FIG. 2C. In the specific embodiment, the screen printing plate 1 of the present invention is composed of the frame 10a, the mesh component 10, and the patterned blocking layer 40 from top to bottom. Wherein, in this specific embodiment, the patterned blocking layer 40 is composed of a first emulsion layer 20 and a second emulsion layer 30. In the manufacturing process, the first emulsion layer 20 is applied on the substrate contact surface 103 of the mesh component 10 and dried to cure. Then, after the process of the patterned film exposure, development, and drying treatment, the first emulsion layer 20 can be sealed onto the mesh corresponding to the printing material non-discharge area 104c, thereby inhibiting the printing material penetration. Please refer to FIG. 1, FIG. 2A, FIG. 2B, and FIG. 2C. A first patterned opening 201 is formed at the area without the first emulsion layer 20 applied on. In other words, the size of the first patterned opening 201 is equal to the range of the rectangular area shown in FIG. 1, so that the size of the first patterned opening is equal to the printed object.

Then, the second emulsion layer 30 is applied on the first emulsion layer 20, and the manufacturing method is the same as that of the first emulsion layer 20, resulting in the second emulsion layer 30 being located on the partial bottom surface of the first emulsion layer 20. It is worth to note that the thickness of the second emulsion layer 30 is substantially the same as the height of the three-dimensional object. The height mentioned above can also be referred to as thickness.

As shown in FIG. 1, the first patterned opening 201 is a rectangular hole, which has four sidewalls. The four sidewalls in order are the upper sidewall 202a, the right sidewall 202b, the lower sidewall 202c and the left sidewall 202d. Wherein, the upper sidewall 202a corresponds to the lower sidewall 202c, and the right sidewall 202b corresponds to the left sidewall 202d. The upper sidewall 202a is connected to the right sidewall 202b and the left sidewall 202d, and the lower sidewall 202c is connected to the right sidewall 202b and the left sidewall 202d.

As shown in FIG. 2A to FIG. 2C, the second emulsion layer 30 has a lateral concave portion. The lateral concave portion corresponds to the first patterned opening 201. Wherein, the lateral concave portion has three side surfaces comprising a top side surface 301a, a right side surface 301b, and a bottom side surface 301c. The top side surface 301a, the right side surface 301b, and the bottom side surface 301c contact and align with the upper sidewall 202a, the right sidewall 202b, and the lower sidewall 202 of the first patterned opening 201 respectively. To be specific, the top side surface 301a contacts and aligns with the upper sidewall 202a; the right side surface 301b contacts and aligns with the right sidewall 202b; the bottom side surface 301c contacts and aligns with the lower sidewall 202c.

Wherein, as shown in FIG. 2B, the area of the mesh component 10 corresponding to the first patterned opening 201 is further divided into the printing material non-discharge area 104c and the printing material discharge area 104. The printing material discharge area 104 corresponds to the first patterned opening 201. The upper sidewall 202a, the top side surface 301a, the right sidewall 202b, the right side surface 301b, the lower sidewall 202c, and the bottom side surface 301c of the first patterned opening 201 are adjacent to the non-three-dimensional object stacking area 104b and jointly form the first limiting wall of the patterned blocking layer 40. In other words, the first limiting wall is formed by stacking the first emulsion layer 20 in a cured state and the second emulsion layer 30 in a cured state, as shown in FIG. 2A to FIG. 2C. The left sidewall 202d is adjacent to the three-dimensional object stacking area 104a, and the second limiting wall of the patterned blocking layer is formed by the left sidewall 202d after curing. Wherein, the thickness h1 of the first limiting wall is larger than the thickness h2 of the second limiting wall.

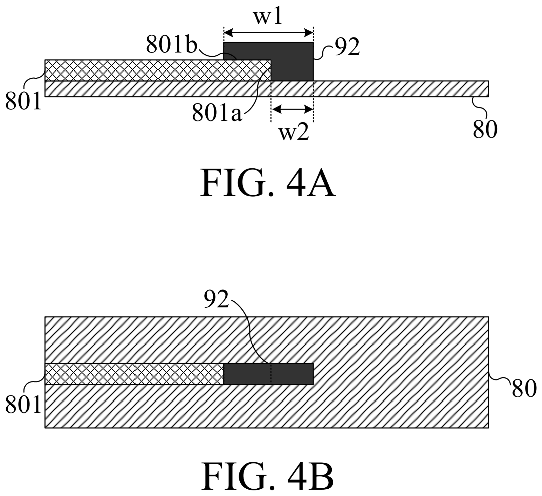

In practical application, the screen printing plate 1 of the present invention can be applied to an edge printing system for three-dimensional objects. Please refer to FIG. 3A, FIG. 3B, FIG. 3C, FIG. 3D, FIG. 4A and FIG. 4B. FIG. 4A is a front view illustrating the substrate after printing. FIG. 4B is a top view illustrating the substrate after printing. Wherein, the edge printing system for three-dimensional objects of the present invention comprises the screen printing plate 1 mentioned above, the substrate 80 having a three-dimensional object 801 disposed on a surface thereof, and a squeegee 90. The printing process will be explained below using FIG. 3A to FIG. 3D.

The first limiting wall and the second limiting wall are positioned above the substrate 80 having a three-dimensional object 801 after the screen printing plate 1 is disposed on the substrate 80. In other words, the first limiting wall and the second limiting wall do not contact the substrate 80. The first limiting wall is located above the substrate 80, and is different from one side of the three-dimensional object 801 of the substrate 80. In detail, the first limiting wall is located on the right side of the substrate 80 and the orthographic projection of the first limiting wall onto the substrate 80 cannot overlap with the three-dimensional object 801 when the three-dimensional object 801 is located on the left side of the substrate 80. Therefore, the printing material discharge area 104 and the first patterned opening 201 of the screen printing plate 1 simultaneously cover portion of the three-dimensional object 801 and portion of the substrate 80 within the orthographic projection range of the substrate 80. As shown in FIG. 3A, the three-dimensional object 801 has a side surface 801a and a top surface 801b. Wherein, the portion of the top surface 801b and the side surface 801a of the three-dimensional object 801 are positioned below the first patterned opening 201, that is, the portion of the top surface 801b and the side surface 801a of the three-dimensional object 801 correspond to the projection of the printing material discharge area 104.

Next, the squeegee 90 is configured to push the printing material 91 along the direction of the printing material discharge area 104 within the squeegee contact surface 102 of the mesh component 10, that is, in the direction of the arrow in FIG. 3A. As shown in FIG. 3B, the squeegee 90 applied pressure during the process of pushing the printing material 91, so that the mesh component 10 and the first emulsion layer 20 are deformed downward. As this time, the first emulsion layer 20 presses against and contacts the top surface 801b of the three-dimensional object 801. Due to the printing material discharge area 104 not being covered by the first emulsion layer 20, the printing material 91 can flow out from the substrate contact surface 103 along the mesh 101 of the mesh component 10. The printing material 91 further flows through the first patterned opening 201 when the squeegee 90 pushes the printing material 91 toward the printing material discharge area 104.

In the process of continuous printing, the printing material 91 can continually flow along the mesh 101 from the substrate contact surface 103. As shown in FIG. 3C, the pressure from the squeegee 90 causes the first limiting wall and the substrate 80 to contact when the squeegee 90 moves to the area for printed pattern, that is, the non-three-dimensional object stacking area 104b. The first limiting wall can abut and support the substrate 80, thereby preventing excessive deformation of the mesh component 10 and further avoiding the projected area of the printing material discharge area 104 undergoing significant deformation.

Then, the second limiting wall 202d presses against the top surface 801b of the three-dimensional object while the printing material 91 flows downward toward the substrate 80 through the mesh 101 of the first patterned opening 201. At the same time, three side surfaces of the first limiting wall (i.e., 301a, 302b, and 303c) surround the printing material 91 flowing downward from above, thereby limiting the downward flow of the printing material 91. The mesh component 10, the first limiting wall, and the second limiting wall are no longer subjected to the pressure from the squeegee 90 when the squeegee 90 moves upward after printing, thereby returning to their original positions. At the same time, the flow of the printing material 91 is restricted by three side surfaces of the first limiting wall, resulting in the printing material 91 being prevented from exceeding the printing area defined by the printing material discharge area 104 after the first limiting wall returns to its original position. As shown in FIG. 3D, the printing material 91 forms a coverage layer 92, and the coverage layer 92 is formed at the lateral edge of the three-dimensional object 801 to contact and adhere to the top surface 801b and the side surface 801a of the three-dimensional object 801, and the top surface of the substrate 80.

The screen printing plate 1 moves upward away from the substrate 80 after the printing material 91 forms the coverage layer 92 at the position below the projection of the printing material discharge area 104. Then, as shown in FIG. 4A and FIG. 4B, the coverage layer 92 is located on the lateral edge of the three-dimensional object 801, and simultaneously covers the portion of the top surface 801b and the side surface 801a of the three-dimensional object 801, and the substrate 80. The width w1 of the cross section of the upper half of the coverage layer 92 is larger than the width w2 of the cross section of the lower half of the coverage layer 92.

In other words, the screen printing plate 1 of the present invention can avoid the position of the three-dimensional object 801 and support the pressure of the squeegee 90, thereby forming the coverage layer 92, which is uniform on the top surface. In practice, the printing material 91 can be ink, an electrical insulating material (e.g., silicone, acrylic adhesive, etc.), or a conductive material, such as conductive paste. Moreover, in the invention of the screen printing plate 1, different materials of the printing material 91 can be used with different three-dimensional objects 801. For example, the three-dimensional object 801 can be the positive electrode layer or negative electrode layer of the battery when the printing material 91 is an electrical insulating material, so that the electrical insulating material can be used to form an electrical insulating barrier layer.

In the practical application, the mesh component 10 of the screen printing plate 1 in the present invention can be formed from materials including stainless steel, nylon, or polyester. In order to ensure that the second emulsion layer 30 firmly adheres to the first emulsion layer 20, the first emulsion layer 20 and the second emulsion layer 30 can be made of the same emulsion material, such as photosensitive resin, polyvinyl alcohol, epoxy resin, or other suitable materials. Therefore, the second emulsion layer 30 can prevent detachment after long-term use. The materials of the first emulsion layer and the second emulsion layer are not limited to those described above, and other suitable emulsions can be chosen as required to satisfy particular printing requirements.

Compared with the prior art, the screen printing plate 1 of the present invention is not only applicable to the substrates 80 having different-dimensional objects, but also effectively prevents the screen from deforming downward during squeegee operation in the process of the printing, which would otherwise cause the printing material to have a lower height or become deformed, thereby further improving overall printing stability and yield. Please note that this specific embodiment illustrates only one printing direction, but the printing direction is not limited to this in practice. In another embodiment, the application area of the second emulsion layer is not limited to this, and it is allowed to be slightly greater than the width of the squeegee.

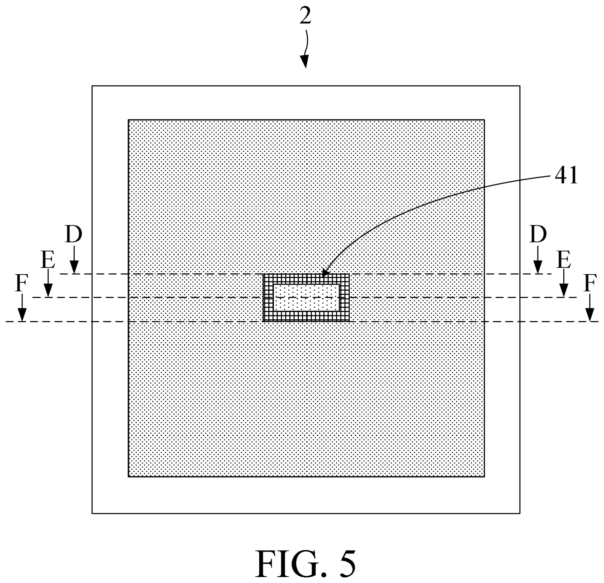

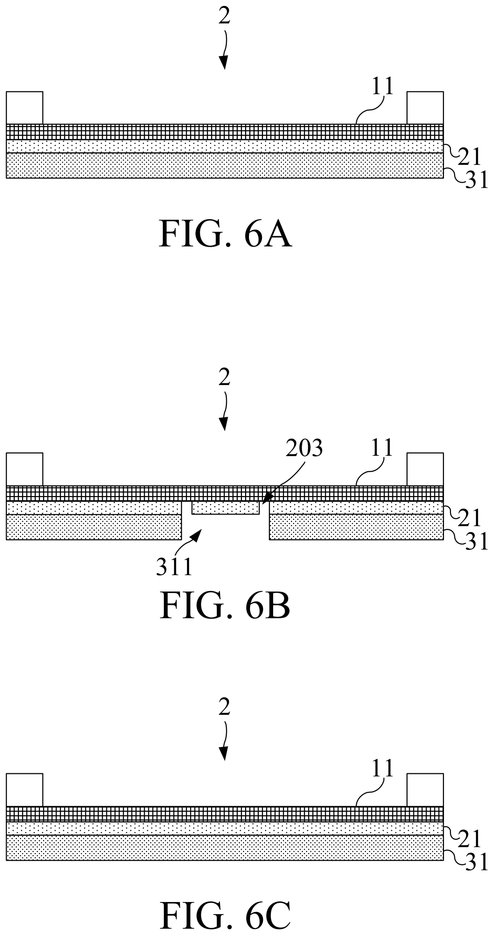

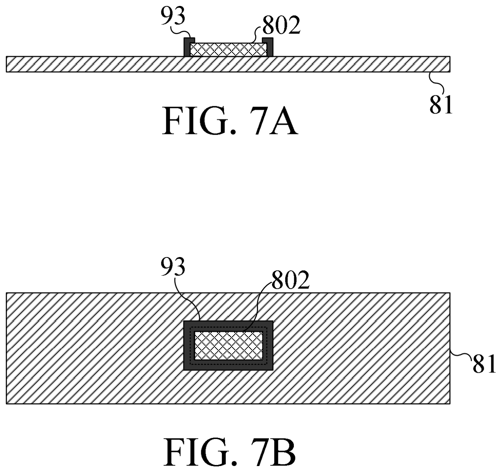

In practice, the screen printing plate of the present invention is not only limited to printing the coverage layer on one side of the three-dimensional object. The invention further provides the embodiment as described below. Please refer to FIG. 5, FIG. 6A, FIG. 6B, FIG. 6C, FIG. 7A and FIG. 7B. FIG. 5 is a top view illustrating the screen printing plate 2 according to one embodiment of the present invention. FIG. 6A is a sectional diagram illustrating the section D-D of the screen printing plate of FIG. 5. FIG. 6B is a sectional diagram illustrating the section E-E of the screen printing plate of FIG. 5. FIG. 6C is a sectional diagram illustrating the section F-F of the screen printing plate of FIG. 5. FIG. 7A is a front view illustrating the substrate 81 after printing. FIG. 7B is a top view illustrating the substrate 81 after printing. As shown in FIG. 5, in this specific embodiment, the pattern of the screen printing plate 2 is a rectangular annular pattern. As shown in FIG. 6A and FIG. 6B, in this specific embodiment, the first emulsion layer 21 of the screen printing plate 2 has the first patterned opening 203 in a rectangular ring shape corresponding to the rectangular annular pattern. Wherein, the inner side of the first patterned opening 203 of the rectangular ring has four sidewalls to form the second limiting wall.

In the actual manufacturing process, the first emulsion layer 21 is applied on the mesh and dried to cure. Then, after the process of the patterned film exposure, development, and drying treatment, the mesh at the center of the rectangular ring pattern 41 on the mesh component 11 and the mesh outside the rectangular ring pattern 41 are covered by the first emulsion layer 21, so as to form the first patterned opening 203 in the rectangular ring shape. Thereafter, the second emulsion layer 31 is applied on the first emulsion layer 21 and the second emulsion layer 31 after undergoing patterned film exposure, development, and drying and curing processes covers the area of the mesh component 11 outside the rectangular ring pattern 41. The second emulsion layer 31 has the second patterned opening 311. The outer dimensions of the second patterned opening 311 are corresponding to the first patterned opening 203 in the rectangular ring shape of the first emulsion layer 21. A limiting area is formed in the center of the second patterned opening 311 to accommodate the three-dimensional object (such as three-dimensional object 802 described in FIG. 7A) and the printing material, so that the projected shapes formed by the first patterned opening 203 and the second patterned opening 311 are different. Wherein, the four side surfaces of the second patterned opening 311, together with the four side surfaces outside the first patterned opening 203, form the first limiting wall. Moreover, the four side surfaces of the second patterned opening 311 are aligned with each of the four side surfaces outside the first patterned opening 203 (FIG. 6A and FIG. 6B show only two of the sides are brought into alignment). In other words, the first limiting wall surrounds the second limiting wall.

Then, please refer to FIG. 7A and FIG. 7B. as shown in FIG. 7A and FIG. 7B, after using the screen printing plate 2 of the present invention, the coverage layer 93 in the rectangular ring shape can be printed on the substrate 81 having the three-dimensional object 802. Please note that the printing method using the squeegee and the printing material is the same as that described in the above embodiment, and is not described in detail herein.

To summarize, the invention provides the screen printing plate and the edge printing system for three-dimensional objects. Wherein, the screen printing plate of the present invention comprises the first emulsion layer and the second emulsion layer. The screen printing plate of the present invention can efficiently control the flow direction of the printing material when printing by controlling the applied region and height of two emulsion layers. Additionally, the squeegee is configured to apply downward pressure to the screen printing plate of the present invention when printing the substrate having the three-dimensional object. The second emulsion layer can be configured to support the mesh component to avoid excessive deformation caused by downward pressure from the squeegee, thereby effectively preventing issues such as uneven printing material height or pattern distortion after printing. Furthermore, the present invention can ensure that the printing material forms a printing layer with a flat top surface, and further forms a complete pattern under the pressure of the squeegee. In summary, compared to the prior art, the present invention provides the screen printing plate and the edge printing system for three-dimensional objects that can be effectively applied to the substrates having the three-dimensional object, while also enabling the printing of stable and complete patterns to meet customer and market demands.

With the examples and explanations mentioned above, the features and spirits of the invention are hopefully well described. More importantly, the present invention is not limited to the embodiment described herein. Those skilled in the art will readily observe that numerous modifications and alterations of the device may be made while retaining the teachings of the invention. Accordingly, the above disclosure should be construed as limited only by the metes and bounds of the appended claims.

## Claims

1. A screen printing plate used for forming a printed object onto a three-dimensional object, the printed object covering a top surface of the three-dimensional object and a side surface adjacent to the top surface, the screen printing plate comprising:
a frame;
a mesh component, disposed on the frame, the mesh component having a squeegee contact surface and a substrate contact surface opposed to the squeegee contact surface; and
a patterned blocking layer, disposed on the substrate contact surface of the mesh component to divide the mesh component into a printing material non-discharge area and a printing material discharge area, the printing material discharge area being corresponding to the three-dimensional object and being divided into a three-dimensional object stacking area and a non-three-dimensional object stacking area;
wherein, the patterned blocking layer forms a first limiting wall in the non-three-dimensional object stacking area, and the patterned blocking layer forms a second limiting wall in the three-dimensional object stacking area, the thickness of the first limiting wall is larger than the thickness of the second limiting wall.

2. The screen printing plate of claim 1, wherein the patterned blocking layer of the first limiting wall is formed by stacking a first emulsion layer in a cured state and a second emulsion layer in a cured state, the patterned blocking layer of the second limiting wall is formed by the first emulsion layer in a cured state.

3. The screen printing plate of claim 2, wherein the thickness of the second emulsion layer is substantially the same as the height of the three-dimensional object.

4. The screen printing plate of claim 2, wherein a material of the second emulsion layer is the same as that of the first emulsion layer.

5. The screen printing plate of claim 1, wherein the first limiting wall surrounds the second limiting wall.

6. An edge printing system for three-dimensional objects, comprising:
a substrate, having a three-dimensional object disposed on a surface thereof;
a screen printing plate, disposed on the surface of the substrate, the screen printing plate comprising:
a frame;
a mesh component, disposed on the frame, the mesh component having a squeegee contact surface and a substrate contact surface opposed to the squeegee contact surface, the substrate contact surface being adjacent to the substrate and the three-dimensional object, and
a patterned blocking layer, disposed on the substrate contact surface of the mesh component to divide the mesh component into a printing material non-discharge area and a printing material discharge area, the printing material discharge area being corresponding to the three-dimensional object and being divided into a three-dimensional object stacking area and a non-three-dimensional object stacking area;
wherein, the patterned blocking layer forms a first limiting wall in the non-three-dimensional object stacking area, and the patterned blocking layer forms a second limiting wall in the three-dimensional object stacking area, the thickness of the first limiting wall is larger than the thickness of the second limiting wall; and
a squeegee, configured to apply pressure on a printing material applied on the squeegee contact surface to allow the printing material to be discharged from the printing material discharge area and to form a coverage layer covering a portion of a top surface of the three-dimensional object and a side surface adjacent to the top surface.

7. The edge printing system for three-dimensional objects of claim 6, wherein the patterned blocking layer of the first limiting wall is formed by stacking a first emulsion layer in a cured state and a second emulsion layer in a cured state, and the patterned blocking layer of the second limiting wall is formed by the first emulsion layer in a cured state.

8. The edge printing system for three-dimensional objects of claim 7, wherein the thickness of the second emulsion layer is substantially the same as the height of the three-dimensional object.

9. The edge printing system for three-dimensional objects of claim 7, wherein a material of the second emulsion layer is the same as that of the first emulsion layer.

10. The edge printing system for three-dimensional objects of claim 6, wherein the first limiting wall surrounds the second limiting wall.
